Europäisches Patentamt

European Patent Office

Office européen des brevets

(19)

(11) **EP 1 015 858 B1**

(12) **EUROPÄISCHE PATENTSCHRIFT**

(45) Veröffentlichungstag und Bekanntmachung des Hinweises auf die Patenterteilung:
**25.09.2002 Patentblatt 2002/39**

(51) Int Cl.$^7$: **G01K 7/01**

(86) Internationale Anmeldenummer:
**PCT/DE98/02123**

(21) Anmeldenummer: **98947351.7**

(22) Anmeldetag: **27.07.1998**

(87) Internationale Veröffentlichungsnummer:
**WO 99/014567 (25.03.1999 Gazette 1999/12)**

(54) **VERFAHREN UND VORRICHTUNG ZUR ERMITTLUNG DES LADESTROMS EINES AKKUMULATORS**

METHOD AND DEVICE FOR DETERMINING THE CHARGING CURRENT OF AN ACCUMULATOR

PROCEDE ET DISPOSITIF POUR DETERMINER LE COURANT DE CHARGE D'UN ACCUMULATEUR

(84) Benannte Vertragsstaaten:
**DE ES FR GB IT**

(30) Priorität: **15.09.1997 DE 19740559**

(43) Veröffentlichungstag der Anmeldung:
**05.07.2000 Patentblatt 2000/27**

(73) Patentinhaber: **SIEMENS AKTIENGESELLSCHAFT 80333 München (DE)**

(72) Erfinder:
• **SCHWARZ, Thomas D-46414 Rhede (DE)**
• **MENZ, Wolfgang D-46499 Hamminkeln (DE)**

(56) Entgegenhaltungen:
**EP-A- 0 526 874**

• **PATENT ABSTRACTS OF JAPAN vol. 010, no. 282 (P-500), 25. September 1986 & JP 61 102529 A (TOSHIBA CORP), 21. Mai 1986**

**Beschreibung**

Die Erfindung bezieht sich auf ein Verfahren zur Ermittlung des Ladestromes und der Temperatur eines Akkumulators.

Weiters bezieht sich die Erfindung auf eine Schaltungsanordnung zur Ermittlung des Ladestroms und der Temperatur eines Akkumulators unter Zuhilfenahme einer Rechen- und Steuereinheit.

Insbesondere in Mobilfunkgeräten, z.B. Schnurlostelefonen, GSM-Handys etc. sollen zur Überwachung der Ladung des eingebauten Akkumulators sowohl der in den Akkumulator fließende Ladestrom als auch die Temperatur des Akkumulators gemessen und mit Hilfe einer in dem Mobilfunkgerät vorhandenen Rechen- und Steuereinheit, z.B. eines Mikroprozessors, überwacht werden.

Es ist bekannt, zur Temperaturmessung einen Spannungsteiler mit einem NTC-Widerstand zu verwenden, der in thermischem Kontakt mit dem Akkumulator steht. Die temperaturabhängige Änderung des Widerstandswertes des NTC-Widerstandes ergibt an dem Spannungsteiler eine Spannungsänderung, die ein Maß für die Temperaturänderung des NTC-Widerstandes und damit des Akkumulators darstellt. Die Kennlinie eines NTC-Widerstandes ist nichtlinear und für genaue Temperaturmessungen muß entweder ein eng tolerierter NTC-Widerstand verwendet werden oder die Schaltung muß bei einer bestimmten Temperatur abgeglichen werden. Die Ausgangsspannung des Spannungsteilers wird üblicherweise mit Hilfe eines A/D-Wandlers in einen digitalen Wert gewandelt, welcher in der Rechen- und Steuereinheit weiterverarbeitet und auch zur Steuerung und Regelung des Ladevorganges, z.B. zur Steuerung eines Ladestromschalters herangezogen werden kann.

Die Messung des Ladestroms erfolgt üblicherweise mit Hilfe eines Meßwiderstandes, d.h. eines von dem Ladestrom durchflossenen Shunts, wobei die an dem Meßwiderstand abfallende Spannung in einer eigenen Verstärkerschaltung verstärkt und dann gleichfalls einem A/D-Wandler zugeführt wird, dessen digitaler Ausgangswert der Rechen- und Steuereinheit zur Verfügung steht.

Diese bekannte, oben beschriebene, Art der Ermittlung von Ladestrom und Akkumulatortemperatur ist verhältnismäßig aufwendig, insbesondere falls eine höhere Genauigkeit der Messungen angestrebt wird.

Es ist eine Aufgabe der Erfindung, ein Verfahren und eine Anordnung zur Ermittlung von Ladestrom und Temperatur eines Akkumulators zu schaffen, die genaue Messungen mit vertretbarem Aufwand ermöglichen. Im besonderen ist es eine Aufgabe der Erfindung, beide benötigte Werte mit Hilfe einer einzigen Schaltungsanordnung zur Verfügung zu stellen.

Diese Aufgaben werden mit einem Verfahren der eingangs genannten Art gelöst, bei welchem erfindungsgemäß ein Teil des Ladestroms über einen Transistor verstärkt wird, welcher in thermischem Kontakt mit dem Akkumulator steht, eine Ausgangsspannung der Transistorverstärkerschaltung zur Ermittlung eines Referenzwertes einmalig bei einer bekannten Temperatur gemessen wird, sodann bei der zu ermittelnden Temperatur bei abgeschaltetem Ladestrom die Ausgangsspannung und bei derselben Temperatur die Ausgangsspannung bei eingeschaltetem Ladestrom gemessen wird und sodann aus dem Referenzwert, der Spannung bei abgeschaltetem Ladestrom und der Spannung bei eingeschaltetem Ladestrom rechnerisch die Temperatur und der Ladestrom ermittelt werden.

Die Erfindung nutzt die Temperaturabhängigkeit der Basis-Emitter-Spannung eines Transistors, der in einer Verstärkerschaltung für den Ladestrom arbeitet, sodaß durch entsprechende Auswertung einer einzigen Ausgangsspannung bei ein- und ausgeschaltetem Ladestrom sowohl die Temperatur als auch der Ladestrom ermittelt werden können. Da ein Mikroprozessor sowie ein gesteuerter Ladestromschalter in den üblichen Anwendungsfällen ohnedies zur Verfügung stehen, ist der benötigte Aufwand an Bauteilen minimal.

Eine sehr einfache Ermittlung des Ladestroms ergibt sich, wenn der Ladestrom I nach der Formel $I = (U_{A,I} - U_{A,O})/V_I$ rechnerisch ermittelt wird, wobei $V_I$ die Verstärkung $\Delta U_A/\Delta I$ der Transistorschaltung für Stromänderungen bedeutet.

Andererseits läßt sich die Temperatur leicht ermitteln, wenn die Temperatur T nach der Formel $T = T_0 + (U_{A,O} - U_{A,Ref})/V_T$ rechnerisch ermittelt wird, wobei $V_T$ die Verstärkung $\Delta U_A/\Delta T$ der Transistorschaltung für Temperaturänderungen bedeutet.

Mit Vorteil wird bei der Erfindung ein Siliziumtransistor verwendet, da sich die Temperaturabhängigkeit der Basis-Emitter-Spannung eines Si-Transistors für die gegenständlichen Zwecke besonders eignet.

Die gestellte Aufgabe wird weites mit einer Schaltungsanordnung der zu Beginn erwähnten Art gelöst, bei welcher erfindungsgemäß ein in einer Verstärkerschaltung betriebener Transistor in thermischem Kontakt mit dem Akkumulator gebracht ist, der Ladestrom dem Akkumulator über einen gesteuerten Ladestromschalter zugeführt ist, ein Teil des Ladestroms dem Eingang der Verstärkerschaltung zugeführt ist und eine Ausgangsspannung der Verstärkerschaltung einer Rechen- und Steuereinheit zugeführt ist, über welche auch der Schalter gesteuert ist, wobei die Rechen- und Steuereinheit dazu eingerichtet ist, aus einem bei geöffnetem Ladestromschalter und bekannter Temperatur ermittelten Referenzwert der Ausgangsspannung, aus dem bei der zu ermittelten Temperatur und geöffnetem Ladestromschalter ermittelten Wert der Ausgangsspannung sowie aus dem bei der zu ermittelten Temperatur und bei eingeschaltetem Ladestrom ermittelten Wert der Ausgangsspannung die Temperatur und den Ladestrom zu berechnen.

Die Vorteile einer solchen Schaltungsanordnung liegen in der mit geringem Aufwand erzielbaren hohen Genauigkeit der ermittelten Werte von Temperatur und Ladestrom eines Akkumulators. Die Schaltung wurde vorrangig für den Einsatz in Mobilfunkgeräten entwickelt, z.B. für Schnurlostelefone, die an einer Basisstation oder in einer Ladeschale geladen werden, doch ist sie prinzipiell für andere Arten von akkumulatorbetriebenen elektronischen Geräten, wie Radios, Fernseher, Laptops, etc. geeignet.

Zur einfachen Ermittlung des Ladestroms empfiehlt es sich, wenn die Rechen- und Steuereinheit dazu eingerichtet ist, den Ladestrom I nach der Formel I= $(U_{A,I} - U_{A,O})/V_I$ zu ermitteln, wobei $V_I$ die Verstärkung $\Delta U_A/\Delta T$ der Transistorschaltung für Stromänderungen bedeutet.

Die Temperatur läßt sich mit wenig Aufwand ermitteln, falls die Rechen- und Steuereinheit dazu eingerichtet ist, die Temperatur T nach der Formel $T=T_0+ (U_{A,0} - U_{A,Ref})/V_T$ zu ermitteln, wobei $V_T$ die Verstärkung $\Delta U_A/\Delta T$ der Transistorschaltung für Temperaturänderungen bedeutet.

Die Erfassung des Ladestroms gestaltet sich besonders einfach, falls in dem Ladestromzweig ein Meßwiderstand liegt und der Spannungsabfall an diesem Widerstand der Verstärkerschaltung zugeführt ist. Dabei kann zweckmäßigerweise der Spannungsabfall der Basis des Transistors über einen Basiswiderstand zugeführt werden.

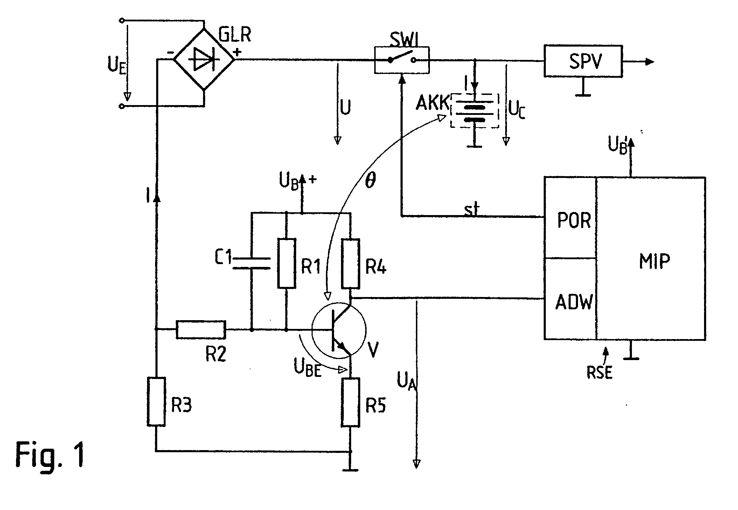

Die Erfindung samt weiterer Vorteile ist im folgenden unter Bezugnahme auf die Zeichnung näher erläutert, welche ein vereinfachtes Blockschaltbild einer Ladeschaltung mit näheren Details zu der Verstärkerschaltung zeigt.

Wie der einzigen Figur der Zeichnung entnehmbar, wird eine Gleichspannung U über einen gesteuerten Schalter SWI einem Akkumulator AKK zugeführt. Der Strom I verläuft dabei von dem positiven Pol der Gleichspannung U über den Akkumulator AKK, über Masse und einen Meßwiderstand R3 zu dem negativen Pol der Gleichspannung U. Diese Spannung U kann beispielsweise über einen Gleichrichter GLR von einer Eingangsspannung $U_E$, im allgemeinen einer Wechselspannung, stammen. Die Akkumulatorspannung $U_C$ steht dem hier nicht gezeigten Verbraucher zur Verfügung, oft unter Zwischenschaltung einer Spannungsversorgungseinheit SPV, die beispielsweise einen geregelten Gleichspannungs/Gleichspannungswandler enthält.

An dem Meßwiderstand R3 entsteht ein dem Strom I proportionaler Spannungsabfall, der einer Verstärkerschaltung mit einem Transistor V, hier einem npn-Siliziumtransistor zugeführt wird. Der Transistor V liegt mit seinem Kollektor über einem Kollektorwiderstand R4 an einer Versorgungsspannung $U_B$. Die Schaltung zeigt weiters einen Emitterwiderstand R5 und einen Basiswiderstand R2. Zur Arbeitspunkteinstellung dient auch ein Widerstand R1, der zwischen der positiven Versorgungsspannung $U_B$ und der Basis des Transistors liegt und der von einem Siebkondensator C1 überbrückt ist.

Die Ausgangsspannung $U_A$ der Verstärkerschaltung ist einem Analog/Digital-Wandler ADW einer Rechen- und Steuereinheit RSE zugeführt, die auch einen Mikroprozessor MIP und einen Ausgangsport POR enthält, von dem eine Steuerleitung ST zu dem gesteuerten Schalter SWI führt. Die Rechen- und Steuereinheit RSE wird an einer Spannung $U_B$ betrieben, die identisch mit der Spannung $U_B$ sein kann, und eine solche Einheit ist beispielsweise ohnehin ein einem Mobilteil eines Mobilfunk- oder Schnurlostelefonsystems enthalten.

Im folgenden wird die Schaltung und das Verfahren nach der Erfindung, insbesondere die Ermittlung der Temperatur T und des Ladestroms I des Akkumulators AKK näher erläutert, wozu vorerst zu bemerken ist, daß Transistor V und Akkumulator AKK in engem thermischem Kontakt stehen, was durch einen Pfeil θ angedeutet ist.

Für die Größe des Ladestroms I ist die Spannung an dem Meßwiderstand R3 maßgeblich, für die Temperatur die Basis-Emitter-Spannung $U_{BE}$ des Transistors V. Diese Spannung ist temperaturabhängig, wobei für Silizium $\Delta U_{BE}/\Delta T=S(T)=-1,85mV/K$.

Zunächst muß bei abgeschaltetem Ladestrom und bekannter Temperatur $T_0$ eine einmalige Referenzmessung erfolgen und sodann wird jeweils bei Ladestrom und ohne Ladestrom die Ausgangsspannung festgestellt.

Die Verstärkung $V_I$ der als Beispiel dargestellten Schaltung für den Ladestrom ergibt sich wie folgt:

$$V_I = \frac{\Delta U_A}{\Delta I}$$

$$\Delta U_{R3} = -R_3 \cdot \Delta I$$

$$\Delta U_B = \Delta U_{R3} \cdot \frac{R_1}{R_1+R_2} = -\Delta I \frac{R_1 \cdot R_3}{R_1+R_2}$$

$$\Delta U_A = -\Delta U_B \cdot \frac{R_4}{R_5} = \Delta I \frac{R_1 \cdot R_3 \cdot R_4}{(R_1+R_2) \cdot R_5}$$

$$V_I = \frac{\Delta U_A}{\Delta I} = \frac{R_1 \cdot R_3 \cdot R_4}{(R_1+R_2) \cdot R_5}$$

Die Verstärkung $V_T$ für die Temperatur ergibt sich folgendermaßen

$$V_T = \frac{\Delta U_A}{\Delta T}$$

$$\Delta U_A = \Delta U_{BE} \cdot \frac{R_4}{R_5}$$

$$V_T = \frac{\Delta U_A}{\Delta T} = \frac{\Delta U_{BE}}{\Delta T} \cdot \frac{R_4}{R_5} = s(T) \cdot \frac{R_4}{R_5}$$

Bei $T=T_0$ und $I=0$ wird der Referenzwert $U_{ARef}$ bestimmt, beispielsweise bei der Fertigung des entsprechenden Gerätes, und in der Rechen- und Steuereinheit abgespeichert.

Zur Ermittlung der jeweils aktuellen Werte von T und I wird

bei I=0     der Wert $U_{A,0}$
bei I       der Wert $U_{A,I}$

beides bei der Temperatur T ermittelt.

Ladestrom und Temperatur lassen sich dann wie folgt berechnen

$$I = \frac{U_{A,I} - U_{A,O}}{V_I}$$

$$T = T_0 + \frac{U_{A,O} - U_{A,ref}}{V_T}$$

Diese Messungen und Berechnungen könne problemlos zu jedem beliebigen Zeitpunkt mit Hilfe der Verstärkerschaltung bzw. des Mikroprozessors MIP durchgeführt werden und auf Grund der ermittelten Werte von I und T erfolgen die erforderlichen Regel- und Steuerungsmaßnahmen, beispielsweise das Schalten des Ladestromschalters SWI.

Die offensichtlichen Vorteile der Erfindung liegen darin, daß nur noch ein A/D-Wandler benötigt wird. Für die Verstärkerschaltung werden lediglich sieben Bauelemente, nämlich ein Transistor, fünf Widerstände und ein Kondensator benötigt, ein Abgleich der Schaltung ist nicht erforderlich, lediglich eine einmalige Referenzmessung.

Es versteht sich für den Fachmann, daß die Verstärkerschaltung auch modifiziert werden kann, wobei lediglich wesentlich ist, daß deren Ausgangsspannung sowohl von dem Ladestrom als auch von der Basis-Emitter-Spannung des Transistors abhängt.

**Patentansprüche**

1. Verfahren zur Ermittlung des Ladestromes ($I_L$) und der Temperatur (T) eines Akkumulators, **dadurch gekennzeichnet, daß**
   ein Teil des Ladestroms ($I_L$) über einen Transistor (V) verstärkt wird, welcher in thermischem Kontakt mit dem Akkumulator steht,
   eine Ausgangsspannung ($U_A$) der Transistorverstärkerschaltung zur Ermittlung eines Referenzwertes ($U_{A,Ref}$) einmalig bei einer bekannten Temperatur ($T_0$) gemessen wird,
   sodann bei der zu ermittelnden Temperatur (T) bei abgeschaltetem Ladestrom die Ausgangsspannung ($U_{A,O}$) und
   bei derselben Temperatur die Ausgangsspannung ($U_{A,I}$) bei eingeschaltetem Ladestrom (I) gemessen wird und
   sodann aus dem Referenzwert ($U_{A,Ref}$), der Spannung ($U_{A,O}$) bei abgeschaltetem Ladestrom und der Spannung ($U_{A,I}$) bei eingeschaltetem Ladestrom rechnerisch die Temperatur (T) und der Ladestrom (I) ermittelt werden.

2. Verfahren nach Anspruch 1, **dadurch gekennzeichnet, daß** der Ladestrom (I) nach der Formel $I = (U_{A,I} - U_{A,O})/V_I$ rechnerisch ermittelt wird, wobei $V_I$ die Verstärkung $\Delta U_A / \Delta I$ der Transistorschaltung für Stromänderungen bedeutet.

3. Verfahren nach Anspruch 1, **dadurch gekennzeichnet, daß** die Temperatur (T) nach der Formel $T = T_0 + (U_{A,O} - U_{A,Ref})/V_T$ rechnerisch ermittelt wird, wobei $V_T$ die Verstärkung $\Delta U_A / \Delta T$ der Transistorschaltung für Temperaturänderungen bedeutet.

4. Verfahren nach einem der Ansprüche 1 bis 3, bei welchem der Transistor (T) ein Siliziumtransistor ist.

5. Schaltungsanordnung zur Ermittlung des Ladestroms (I) und der Temperatur (T) eines Akkumulators (AKK) unter Zuhilfenahme einer Rechen- und Steuereinheit (RSE), **dadurch gekennzeichnet, daß**
   ein in einer Verstärkerschaltung betriebener Transistor (V) in thermischem Kontakt mit dem Akkumulator (AKK) gebracht ist,
   der Ladestrom (I) dem Akkumulator (AKK) über einen gesteuerten Ladestromschalter (SWI) zugeführt ist,
   ein Teil des Ladestromes (I) dem Eingang der Verstärkerschaltung zugeführt ist und
   eine Ausgangsspannung ($U_A$) der Verstärkerschaltung einer Rechen- und Steuereinheit (RSE) zugeführt ist, über welche auch der Schalter (SWI) gesteuert ist,
   wobei die Rechen- und Steuereinheit (RSE) dazu eingerichtet ist, aus einem bei geöffnetem Ladestromschalter (SWI) und bekannter Temperatur ($T_0$) ermittelten Referenzwert ($U_{A,Ref}$) der Ausgangsspannung, aus dem bei der zu ermittelten Temperatur (T) und geöffnetem Ladestromschalter ermittelten Wert ($U_{A,O}$) der Ausgangsspannung sowie aus dem bei der zu ermittelten Temperatur (T) und bei eingeschaltetem Ladestrom (I) ermittelten Wert

($U_{A,I}$) der Ausgangsspannung die Temperatur (T) und den Ladestrom (I) zu berechnen.

**6.** Schaltungsanordnung nach Anspruch 5, **dadurch gekennzeichnet, daß** die Rechen- und Steuereinheit (RSE) dazu eingerichtet ist, den Ladestrom (I) nach der Formel $I=(U_{A,I}-U_{A,O})/V_I$ zu ermitteln, wobei $V_I$ die Verstärkung $\Delta U_A/\Delta T$ der Transistorschaltung für Stromänderungen bedeutet.

**7.** Schaltungsanordnung nach Anspruch 5, **dadurch gekennzeichnet, daß** die Rechen- und Steuereinheit (RSE) dazu eingerichtet ist, die Temperatur (T) nach der Formel $T=T_0+(U_{A,0} - U_{A,Ref})/V_T$ zu ermitteln, wobei $V_T$ die Verstärkung $\Delta U_A/\Delta T$ der Transistorschaltung für Temperaturänderungen bedeutet.

**8.** Schaltungsanordnung nach einem der Ansprüche 1 bis 7, **dadurch gekennzeichnet, daß** in dem Ladestromzweig ein Meßwiderstand (R3) liegt und der Spannungsabfall an diesem Widerstand der Verstärkerschaltung zugeführt ist.

**9.** Schaltungsanordnung nach Anspruch 8, **dadurch gekennzeichnet, daß** der Spannungsabfall der Basis des Transistors (T) über einen Basiswiderstand (R2) zugeführt ist.

**10.** Schaltungsanordnung nach einem der Ansprüche 5 bis 9, bei welcher der Transistor (V) ein Siliziumtransistor ist.

**Claims**

**1.** Method for determining the charging current ($I_L$) and the temperature (T) of a rechargeable battery, **characterized in that**
a portion of the charging current ($I_L$) is amplified via a transistor (V) which is in thermal contact with the rechargeable battery,
an output voltage ($U_A$) of the transistor amplifier circuit is measured once at a known temperature ($T_0$) in order to determine a reference value ($U_{A,Ref}$),
the output voltage ($U_{A,O}$) is then measured at the temperature (T) to be determined with the charging current switched off, and
the output voltage ($U_{A,I}$) is then measured at the same temperature with the charging current (I) switched on, and
the temperature (T) and the charging current (I) are then determined by calculation from the reference value ($U_{A,Ref}$), the voltage ($U_{A,O}$) with the charging current switched off, and the voltage ($U_{A,I}$) with the charging current switched on.

**2.** Method according to Claim 1, **characterized in that** the charging current (I) is determined by calculation using the formula $I = (U_{A,I} - U_{A,O})/V_I$, $V_I$ denoting the gain $\Delta U_A/\Delta I$ of the transistor circuit for changes in current.

**3.** Method according to Claim 1, **characterized in that** the temperature (T) is determined by calculation using the formula $T = T_0 + (U_{A,O} - U_{A,Ref})/V_T$, $V_T$ denoting the gain $\Delta U_A/\Delta T$ of the transistor circuit for changes in temperature.

**4.** Method according to one of Claims 1 to 3, in which the transistor (T) is a silicon transistor.

**5.** Circuit arrangement for determining the charging current (I) and the temperature (T) of a rechargeable battery (AKK) with the assistance of a computing and control unit (RSE), **characterized in that**
a transistor (V) operated in an amplifier circuit is brought into thermal contact with the rechargeable battery (AKK),
the charging current (I) is fed to the rechargeable battery (AKK) via a controlled charging current switch (SWI),
a portion of the charging current (I) is fed to the input of the amplifier circuit and
an output voltage ($U_A$) of the amplifier circuit is fed to a computing and control unit (RSE) via which the switch (SWI) is also controlled,
the computing and control unit (RSE) being set up to calculate the temperature (T) and the charging current (I) from a reference value ($U_{A,Ref}$), determined with an open charging current switch (SWI) and a known temperature ($T_0$), of the output voltage, from the value ($U_{A,O}$), determined at the temperature (T) to be determined and with an open charging current switch, of the output voltage, and from the value ($U_{A,I}$), determined at the temperature (T) to be determined and with a charging current (I) switched on, of the output voltage.

**6.** Voltage arrangement according to Claim 5, **characterized in that** the computing and control unit (RSE) is set up for the purpose of determining the charging current (I) using the formula $I = (U_{A,I} - U_{A,O})/V_I$, $V_I$ denoting the gain $\Delta U_A/\Delta T$ of the transistor circuit for changes in current.

**7.** Circuit arrangement according to Claim 5, **characterized in that** the computing and control unit (RSE) is set up to determine the temperature (T) using the formula $T = T_0 + (U_{A,0} - U_{A,Ref})/V_T$, $V_T$ denoting the gain $\Delta U_A/\Delta T$ of the transistor circuit for temperature changes.

**8.** Circuit arrangement according to one of Claims 1 to 7, **characterized in that** a measuring shunt (R3) is situated in the charging current branch, and the voltage drop across this resistor is fed to the amplifier circuit.

**9.** Circuit arrangement according to Claim 8, **characterized in that** the voltage drop is fed to the base of the transistor (T) via a base resistor (R2).

**10.** Circuit arrangement according to one of Claims 5 to 9, in which the transistor (V) is a silicon transistor.

## Revendications

**1.** Procédé pour déterminer le courant de charge ($I_L$) et la température (T) d'un accumulateur, **caractérisé en ce que**

on amplifie une partie du courant de charge ($I_L$) par l'intermédiaire d'un transistor (V) lequel est en contact thermique avec l'accumulateur,

on mesure une tension de sortie ($U_A$) du montage amplificateur à transistor une seule fois à une température connue ($T_0$) afin de déterminer une valeur de référence ($U_{A, Ref}$),

puis on mesure la tension de sortie ($U_{A, 0}$) à la température à déterminer (T) hors courant de charge et

la tension de sortie ($U_{A, I}$) à la même température sous courant de charge (I),

puis on détermine par calcul la température (T) et le courent de charge (I) à partir de la valeur de référence ($U_{A, Ref}$), de la tension ($U_{A, 0}$) hors courant de charge et de la tension ($U_{A, I}$) sous courant de charge.

**2.** Procédé selon la revendication 1, **caractérisé en ce qu'**on détermine par calcul le courant de charge (I) selon la formule I = ($U_{A, I}$ - $U_{A, 0}$) / $V_I$, $V_I$ étant l'amplification $\Delta U_A / \Delta_I$ du montage à transistor pour des variations de courant.

**3.** Procédé selon la revendication 1, **caractérisé en ce qu'**on détermine par calcul la température (T) selon la formule T = $T_0$ + ($U_{A, 0}$ - $U_{A, Ref}$) / $V_T$, $V_T$ étant l'amplification $\Delta U_A / \Delta_T$ du montage à transistor pour des variations de température.

**4.** Procédé selon l'une des revendications 1 à 3, dans lequel le transistor (V) est un transistor au silicium.

**5.** Montage pour déterminer le courant de charge (I) et la température (T) d'un accumulateur (AKK) à l'aide d'une unité de calcul et de commande (RSE), **caractérisé en ce que**

un transistor (V) mis en oeuvre dans un montage amplificateur est mis en contact thermique avec l'accumulateur (AKK),

le courant de charge (I) est amené à l'accumulateur (AKK) par l'intermédiaire d'un disjoncteur de courant de charge (SWI) commandé,

une partie du courant de charge (I) est amenée à l'entrée du montage amplificateur et

une tension de sortie ($U_A$) du montage amplificateur est amenée à une unité de calcul et de commande (RSE), par l'intermédiaire de laquelle est commandé également le disjoncteur (SWI),

l'unité de calcul et de commande (RSE) étant configurée de manière à calculer la température (T) et le courant de charge (I) à partir d'une valeur de référence ($U_{A, Ref}$) de la tension de sortie, déterminée à disjoncteur de courant de charge (SWI) ouvert et température connue ($T_0$), à partir de la valeur ($U_{A, 0}$) de la tension de sortie, déterminée à la température à déterminer (T) et à disjoncteur de courant de charge ouvert, ainsi qu'à partir de la valeur ($U_{A, I}$) de la tension de sortie, déterminée à la température à déterminer (T) et sous courant de charge (I).

**6.** Montage selon la revendication 5, **caractérisé en ce que** l'unité de calcul et de commande (RSE) est configurée de manière à déterminer le courant de charge (I) selon la formule I = ($U_{A, I}$ - $U_{A, 0}$) / $V_I$, $V_I$ étant l'amplification $\Delta U_A / \Delta_T$ du montage à transistor pour des variations de courant.

**7.** Montage selon la revendication 5, **caractérisé en ce que** l'unité de calcul et de commande (RSE) est configurée de manière à déterminer la température (T) selon la formule T = $T_0$ + ($U_{A, 0}$ - $U_{A, Ref}$) /$V_T$, $V_T$ étant l'amplification $\Delta U_A / \Delta_T$ du montage à transistor pour des variations de température.

**8.** Montage selon l'une des revendications 1 à 7, **caractérisé en ce qu'**une résistance de mesure (R3) est placée dans le bras de courant de charge et que la chute de tension est amenée au montage amplificateur au niveau de cette résistance.

**9.** Montage selon la revendication 8, **caractérisé en ce que** la chute de tension est amenée à la base du transistor (V) par l'intermédiaire d'une résistance de base (R2).

**10.** Montage selon l'une des revendications 5 à 9, dans lequel le transistor (V) est un transistor au silicium.

Fig. 1

7